(19) Europäisches Patentamt / European Patent Office / Office européen des brevets

(11) **EP 2 477 330 A2**

(12) **EUROPEAN PATENT APPLICATION**

(43) Date of publication:
**18.07.2012 Bulletin 2012/29**

(51) Int Cl.:
*H03G 3/30* (2006.01)

(21) Application number: **11153048.1**

(22) Date of filing: **02.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.01.2011 US 5001**

(71) Applicant: **Autotalks Ltd.**
**40593 Kfar Netter (IL)**

(72) Inventors:
• **Haran, Onn**
**45815 Bnei Dror (IL)**
• **Tsodik, Genadiy**
**Givatayim (IL)**

(74) Representative: **Modiano, Micaela Nadia et al**
**Modiano & Partners**
**Thierschstrasse 11**
**80538 München (DE)**

(54) **Adjacent channel interference mitigation during the acquisition phase in OFDM communications**

(57) Methods and apparatuses for adjacent channel interference mitigation during the acquisition phase in OFDM communications use a Discrete Fourier Transform (DFT) to detect the energy of a received channel without adding latency. In particular embodiments, the communications are vehicular OFDM communications and the DFT is a sliding DFT of variable length, In a typical acquisition procedure, RF gain is set based on received total energy, which includes energies of the received and adjacent channels. A modified state machine waits until the energy of a received channel is detected, then the RF gain is adjusted to fulfill an enhanced adjacent channel rejection criterion requirement.

FIG. 1a

## Description

FIELD AND BACKGROUND

Embodiments of the invention relate generally to communications employing orthogonal frequency-division multiplexing (OFDM). More particularly, embodiments of the invention relate to adjacent channel interference mitigation during the acquisition (initial receive) phase in vehicular (vehicle-to-vehicle and vehicle-to-infrastructure) OFDM communications. The application of OFDM to vehicular communications is described in more detail in PCT patent application PCT/IB2010/055197 titled "Systems and methods for improving communications in ad-hoc vehicular networks" and filed 16 November 2010, which is incorporated herein by reference in its entirety.

In the US and Europe, vehicular communications are allocated seven channels. Each channel (except the two "end" channels at the boundary of the allocated spectrum) has two immediately neighboring ("adjacent") channels. A receiver is tuned to a specific ("received") channel, while communication activity (i.e. transmission) may potentially take place on the other channels. In particular, transmissions may take place in the channel(s) immediately adjacent to the received channel. For effective network operation, the performance degradation resulting from such adjacent channel activity should be minimized. The criterion (for 10% packet error rate) defined by the IEEE802.11-2007 standard for adjacent channel rejection is that an adjacent channel energy level be higher than a received channel energy level, where the received channel energy level is set 3dB above the sensitivity threshold. This is determined as 16dB adjacent channel rejection. The new IEEE802.11p-201O standard seeks, optionally, an increased criterion of 28dB adjacent channel rejection. Existing RF implementations were designed with the original IEEE802.11-2007 specification in mind. The IEEE802.11p-2010 suggested 12dB addition to the requirements cannot be supported without new measures.

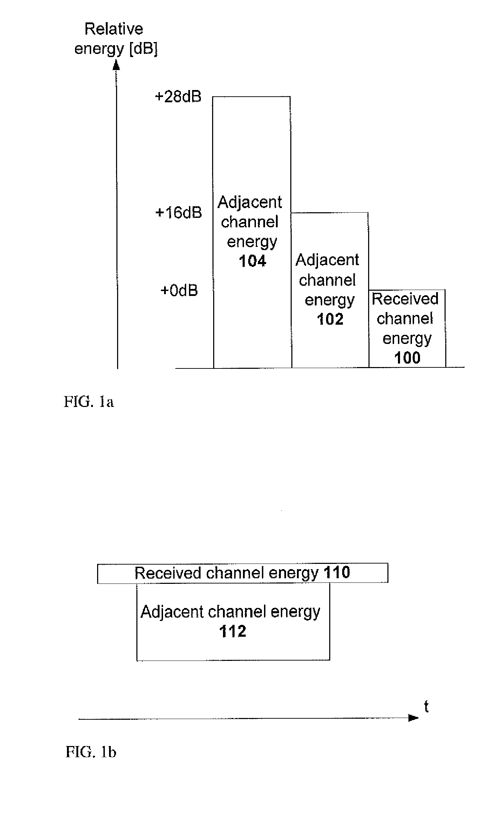

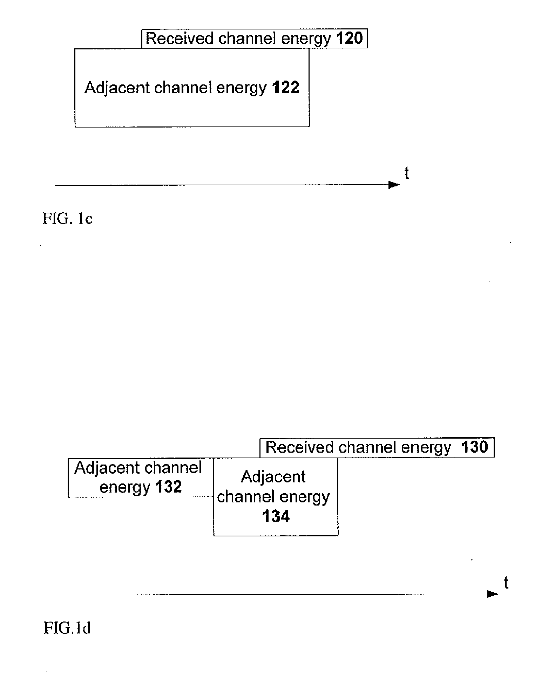

FIG. 1 a illustrates the requirement in terms of energy levels. A packet transmitted in a received channel 100 has a given energy level (exemplarily ca. -79dBm). The energy level of a first adjacent channel 102 represents the original 16dB requirement of an energy level higher than that of the received channel. The energy level of a second adjacent channel 104 represents the new 28dB requirement of an energy level higher than that of the received channel energy.

The correct operation of the receiver does not assume any timing condition between the transmission timing in the received channel and an adjacent channel. FIGS.1b and 1c show schematically the transmission timing of a received channel and of an adjacent channel along a time axis t. In FIG. 1b, the transmission of the received channel arrives before the transmission of an adjacent channel. In FIG. 1c, the transmission of the received channel arrives after the transmission of an adjacent channel. According to the IEEE standard, both cases need to be supported by a solution to adjacent channel interference mitigation during the acquisition phase. FIG. 1d illustrates yet another case which needs to be supported, where the energy values of adjacent channels **132** and **134** change before transmission of received channel 130. The heights of the boxes in FIGS. 1b-1d reflect relative energy levels.

Commonly known adjacent channel interference mitigation techniques are based on lowpass filtering. The filtering is performed in both RF and digital baseband processing. In order to achieve enhanced adjacent channel rejection, one should apply aggressive filters in baseband. An aggressive filter requires many taps, which translates into latency, While latency after the acquisition phase is not an issue, the limited time budget of the acquisition period does not allow the added latency of an aggressive filter.

A RF filter implementation is analog. In order to simplify implementation, the number of analog filter coefficients is typically low. The analog filter frequency response may vary with temperature, so the filter definition must be loose. Consequently, the adjacent channel energy after RF filtering is still unacceptably high. Moreover, the filtering may be performed in several stages, implying a high amount of adjacent channel energy potentially saturating the amplifiers at earlier stages. In the example of FIG. 1c, if the acquisition state machine is occupied with the processing of the adjacent channel energy, then the transmission of the received channel will be missed. As mentioned, the acquisition time budget is limited, and timely decisions are essential.

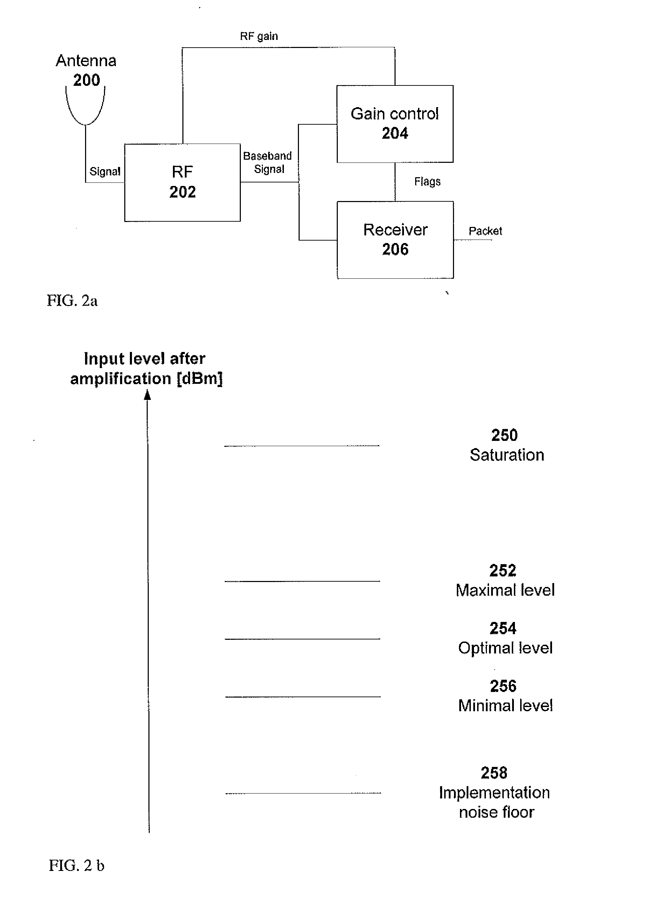

Fig 2a illustrates a typical system block diagram of a known digital modem comprising an antenna **200** which receives information from all channels, a RF component **202** which filters and amplifies these channels, a gain control unit **204** which sets the RF gain during the acquisition and a receiver **206** which processes the information after gain setting. The dynamic range of a digital modem is limited. FIG. 2b illustrates schematically the preferred energy setting of the input signal after RF amplification. A saturation level **250** must not be reached by any signal after amplification. A maximal energy level **252** is set by deducting the maximal allowed adjacent channel energy from the saturation level. For example, if the relevant adjacent channel energy after filtering is 20dB above the received channel energy, then the maximal energy level should be 20dB below the saturation level. An optimal energy level is marked as **254.** This optimal level considers the received channel energy variance during reception. A minimal energy level **256** is required to guarantee sufficient dynamic range above an implementation noise floor **258.**

The guidelines in FIG. 2b have to be met at all cases. For example, in the case shown in FIG. 1b, the RF gain was set according to the energy of received channel 110. Adjacent channel energy 112 must not saturate the amplifiers when the adjacent channel arrives later.

As mentioned, the IEEE specification defines only a single measurement point criterion for adjacent channel mitigation performance — the setting of the received channel energy to 3dB above a sensitivity threshold. This test scheme is clear and simple. However, this definition does not cover all realistic operation scenarios. That is, an implementation may fail all energy levels but one and still pass specification compliance. It is unreasonable to expect that received channels with energy higher than 3dB above a sensitivity level threshold will lead to very low adjacent channel mitigation performance.

There is therefore a need for and it would be advantageous to have methods and apparatuses for RF gain setting in the presence of strong adjacent channel energy, for meeting the harsh interference mitigation requirements of vehicle-to-vehicle and vehicle-to-infrastructure communications specifications.

SUMMARY

Embodiments of the invention disclose methods and apparatuses for RF gain setting in the presence of strong adjacent channel energy, thereby meeting the harsh interference mitigation requirements of OFDM communication specifications in general and vehicular OFDM communications specifications in particular. In an embodiment, a method comprises the steps of setting an RF gain based on received total energy (which includes the energies of a received channel and at least one adjacent channel), waiting until the energy of the received channel is detected and adjusting the RF gain based on the detected energy of the received channel, thereby fulfilling a required criterion specified by a standard such as IEEE802.11-2007 or IEEE802.1 lp-2010. In another embodiment, a method comprises the steps of using a Discrete Fourier Transform (DFT) to detect the energy of a received channel and adjusting an RF gain based on the detected energy of the received channel, thereby fulfilling an adjacent channel rejection criterion requirement in the OFDM communications. In an embodiment, the DFT is a sliding DFT. In another embodiment, the DFT is a dynamic DFT of variable length. In an embodiment, an apparatus operative to perform RF gain setting in the presence of strong adjacent channel energy includes a receive signal strength indicator (RSSI) estimator for measuring the total energy, a sliding DFT for measuring the energy of the received channel; and a state machine used for processing the measured total energy and received channel energy to fulfill an enhanced adjacent channel rejection criterion requirement.

BRIEF DESCRIPTION OF THE DRAWINGS

Non-limiting embodiments of the invention are herein described, by way of example only, with reference to the accompanying drawings, wherein:

FIG. 1a illustrates schematically the ratio between energies of an adjacent channel and a received channel according to IEEE802.11-2007 and IEEE802.11p;
FIG. 1b illustrates schematically along a time axis t the process of an adjacent channel transmission starting after a received channel transmission;
FIG. 1c illustrates schematically along a time axis t the process of an adjacent channel transmission starting before a received channel transmission;
FIG. 1d illustrates a case in which the energy values of two adjacent channels change before transmission of a received channel;
FIG. 2a illustrates a typical system block diagram of a known digital modem;
FIG. 2b illustrates schematically the energy setting of an input signal after RF amplification;
FIG. 3 illustrates in a flow chart an embodiment of a method according to an embodiment of the invention;
FIG. 4 shows in a block diagram an apparatus according to an embodiment of the invention;
FIG. 5 shows an exemplary result obtained with the DFT in the apparatus of FIG. 4 after RF filtering;
FIG. 6 shows details of the operation of state machine in accordance with an embodiment of the invention.

DETAILED DESCRIPTION

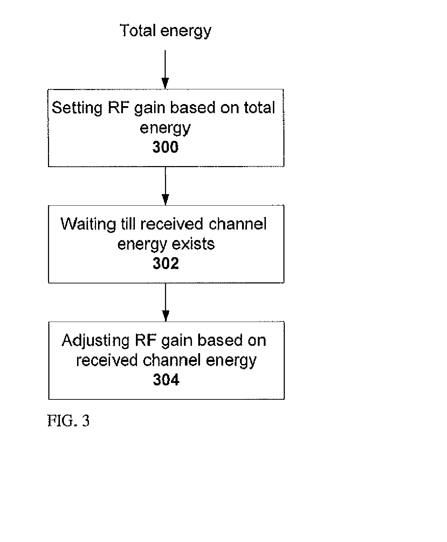

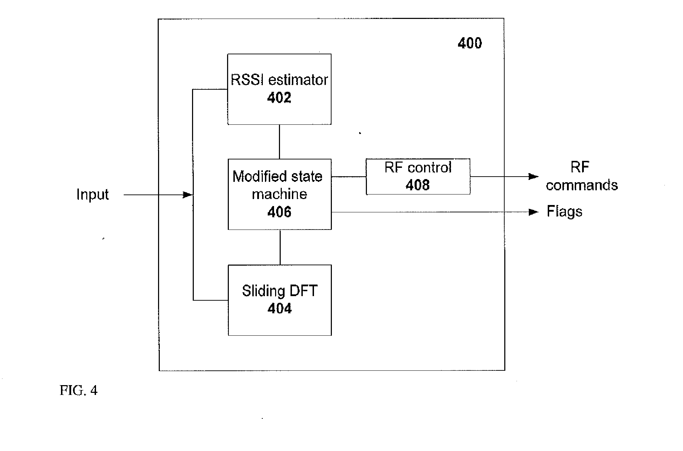

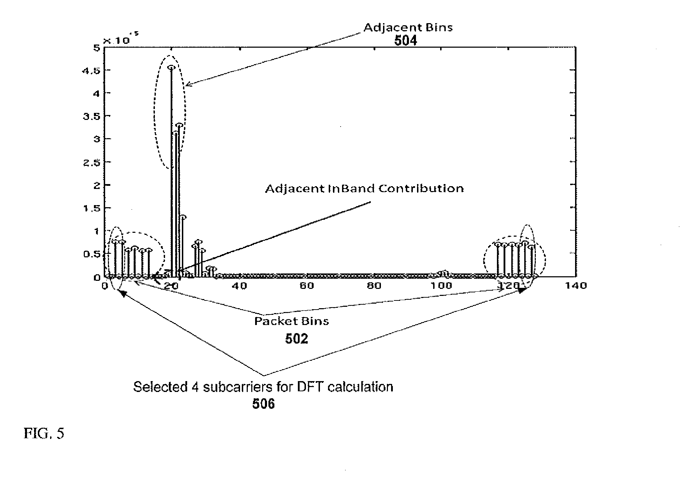

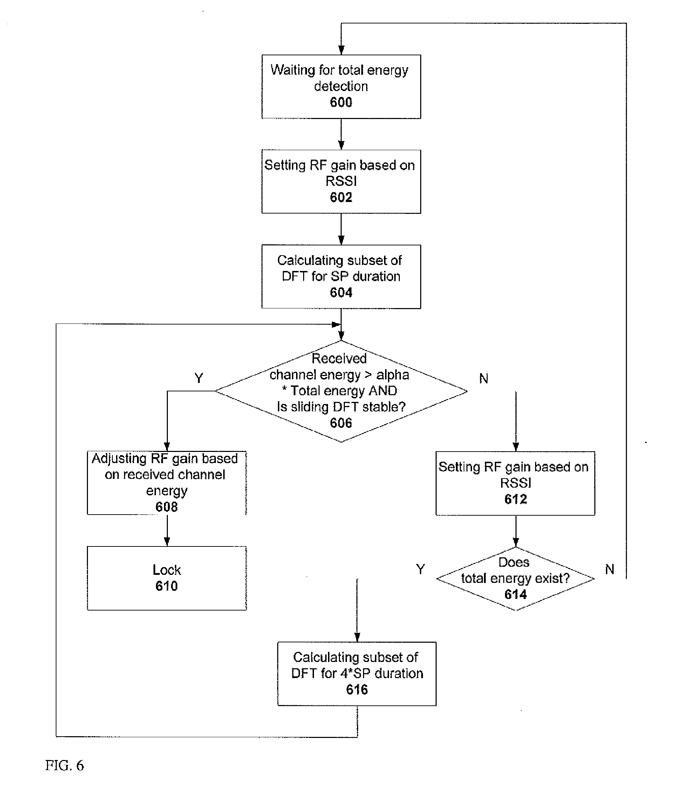

FIG. 3 illustrates in a flow chart an embodiment of a method for adjacent channel interference mitigation during the acquisition phase in OFDM communications, according to an embodiment of the invention. In a particular case, the method is applied to vehicular communications. The process starts with total energy (received channel energy plus adjacent channel energy) as input. In step **300,** the RF gain is set for transforming the input signal energy to roughly the optimal signal energy **254** by a state machine (e.g. **406** in FIG. 4) based on the total energy. In step **302,** the operation of the state machine waits until detection of received channel energy. "Detection" is defined by a ratio $\alpha$ between received channel energy and total energy. Typically, one $\alpha = 1/32$, but other values (e.g. between 0.029~0.033) may be used as well. The transmission in the received channel is detected immediately upon of its arrival, regardless of adjacent channel energy. The detection is performed in a unique way, using a sliding DFT with variable length, instead of traditional filters, for minimizing delay and for detecting received channel energy rather than out-of-band adjacent channel emissions. More details of the sliding DFT operation are given below with respect to FIGS. 5 and 6. Once the received channel energy is detected, the RF gain is adjusted based on the received channel energy in step **304.**

FIG. 4 shows a block diagram of an apparatus **400** for adjacent channel interference mitigation during the acquisition phase in OFDM communications, according to an embodiment of the invention. Normally, the apparatus is part of a vehicular receiver (not shown). Apparatus **400** includes a Receive Signal Strength Indicator (RSSI) estimator **402** for measuring the total energy of input signals, a sliding DFT **404** for detecting received channel energy without adding latency, and a state machine **406** modified to consider output of both blocks **402** and **404** for making decisions which are flags for other modem blocks (not shown) as well as to RF commands issued by an RF control unit **408.** The flags are used to initiate packet detection operation at the receiver. Note that in contrast, known (unmodified) state machines used in OFDM signal acquisition consider only block **402** for decisions. The operation of a modified state machine in embodiments of the invention is described in more detail with reference to FIG. 6.

FIG. 5 shows an exemplary result obtained using a conventional (non-sliding) DFT according to an embodiment of a method of the invention. The adjacent channel energy ("adjacent bins **504"**) is much higher than the received channel energy ("packet bins **502"**) even after RF filtering. The filtering is visible in the diagram. The energy of subcarriers (bins) closer to the received channel frequency is higher than that of.distant subcarriers. In addition, the adjacent channel has leakage inside the received channel limited by the transmission mask. The mask requirement is 30-35dB attenuation for out-of-band emissions. The adjacent channel energy leakage into the received channel is just barely below the received channel energy level. The expectation is that correct operation under these conditions requires the received channel energy level to work 28dB below the adjacent channel energy.

Note that the use of a conventional DFT has two drawbacks if used in this application: high computation effort and long operation duration. The present inventors have determined that the computation effort may be reduced by calculating a subset of the DFT instead of the entire DFT. In an embodiment, the acquisition may be performed when a short preamble (SP) is transmitted (see e.g. PCT/IB2010/055197). IEEE802.11-2007 mandates that during the transmission of the SP, only every 4th subcarrier is transmitted, totaling only 12 subcarriers. The present inventors have further determined that the calculation may be further simplified by having only four subcarriers processed, under the assumption that channel response is mostly flat and that those four subcarriers represent well the channel energy. Advantageously, calculating only this small number of non-zero elements represents a significant simplification from calculating all 64 or 256 DFT values. This way, the overall computation complexity is lower than the filter complexity. Selecting the subcarriers closest to the center frequency minimizes the impact of adjacent channel energy leakage into the received channel. The present inventors have further determined that, at the expense of some accuracy, the calculation may be further simplified by having only two subcarriers processed, under the assumption that channel response is mostly flat and that those two subcarriers represent well the channel energy.

Embodiments of the invention are therefore provided in which the DFT operation duration is addressed in one of two ways:

**Dynamic ("variable") DFT length:** The DFT period is set dynamically to the minimum possible value which still provides an accurate result. After detection of some initial energy (using $\alpha$), it can be assumed that transmissions of received channel and / or adjacent channel have started, and that only the SP is transmitted. The SP period is one quarter of an entire symbol. The length of the DFT is adjusted accordingly to 1.6$\mu$sec (for a 10MHz channel). If the received channel energy is not detected, then the adjacent channel does not transmit a SP, and the DFT length must be increased to support the full symbol period. Consequently, the DFT duration is increased to 6.4$\mu$see. The time budget of the acquisition process is 7*SP period, or 7*1.6 = 11.2$\mu$sec. If the full DFT period was used, then the acquisition process could not meet the time budget, because of the fixed latencies (RF operation and energy measurements). The DFT shortening (adjustment to 1.6$\mu$sec for a 10MHz channel) after initial energy detection is therefore essential for meeting the time budget.

**Sliding DFT:** A conventional DFT provides a result at the end of the DFT period. The sliding DFT was developed by E. Jacobsen and R. Lyons "The Sliding DFT", IEEE Signal Processing Magazine, March 2003, pp. 74-80, which is incorporated herein by reference in its entirety. The calculation takes the form of:

$$X(k)_{n_0+1} = e^{\frac{2\pi i k}{N}}\left[X(k)_{n_0} - x(n_0) + x(n_0 + N)\right]$$

2. where X is the DFT result, x is the time domain sample, N is the DFT window (64 or 256 is embodiments disclosed herein), k is the DFT index (in embodiments disclosed herein, 4 different values selected for calculation) and. $n_0$ is the serial number of the input. The sliding DFT result has two usages: the first is the immediate detection of received channel energy. A strong received channel can be detected after reception of a few inputs. The state machine time budget will be shortened, leaving sufficient time for RF gain adjustment. The second is detection of a received channel out of noise. In case of noise, the energy of a specific subcarrier will be inconsistent, since the DFT result is a noisy leakage and not a consistent subcarrier. The DFT result will therefore vary. Accordingly, embodiments of the invention employ a new stability test added to the state machine. This stability test demands a substantially constant result representing stable energy, thereby separating the received channel transmission from out-of-band emission of an adjacent channel. Exemplarily, consecutive results of the sliding DFT should not have a difference greater than 10%. Note that with respect to FIG. 5, a sliding DFT will yield the same result as a conventional DFT, with the difference that the result will always be available.

3. FIG. 6 shows details of the operation of state machine in accordance with an embodiment of the invention. Operation begins with step 600, in which the state machine waits for energy detection. After energy is detected, the RF gain is set based on RSSI in step 602. Note that steps **600** and 602 are performed by any adaptive gain control state machine. However, known common gain control algorithms fail to support high adjacent channel rejection, since the energy may be of the adjacent channel and not of the received channel. Therefore, the state machine will be busy upon received channel transmission arrival.

In contrast with known methods, in an embodiment of the method disclosed herein, only a subset of DFT during the SP duration is calculated in step 604. Typically, the calculation of the DFT includes calculating only 4 subcarriers (e.g. 506 in FIG. 5). A non-optimized implementation may perform a longer DFT or use aggressive filters, but the time budget will degrade. The shortening of the DFT length provides detection of received channel energy quicker than a filter and is more accurate with lower computation complexity.

In step 606, the DFT result is compared with the total energy (provided by the RSSI). The ratio $\alpha$ between received channel energy and total energy guarantees that the real received channel transmission had begun. Note that consecutive DFT results, received sample by sample, have similar energy level. According to the stability test mentioned above, a maximal allowed variance is 10% between two results. The comparison performed as above enables efficient acquisition under any adjacent channel energy level. If transmission in the received channel is positively detected, then operation continues from step 608 in which the RF gain is adjusted based on received channel energy to obtain the RF gain amplified signal level with optimal energy level 254. The state machine is then declared as "locked" in step 610, ending the packet acquisition.

If transmission in the received channel is not positively detected in step 606, operation continues from step 612 with a "post acquisition" stage. Reasons for transmission not being positively detected in a received channel may include a state in which only the adjacent channel is currently transmitting, or a state in which the received channel energy is weaker than the required energy. In step 612, the RF gain is set based on RSSI. The RF gain setting then follows changes in the adjacent channel. Accurate DFT operation requires a certain input level. The tracking of total energy changes guarantees that the input will remain inside the dynamic range. The total energy may increase if another transmission on the same adjacent channel has started due to a hidden node, or if transmission started on the second adjacent channel. The total energy decreases if transmission ends. Step 614 checks if an adjacent channel transmission is still active by checking the existence of energy. If energy does not exist, the operation returns to step 600. If it exists, a subset of the sliding DFT with the length of symbol duration (4SP) is calculated in step 616, after which operation returns to step 606, using the DFT result to recheck the ratio of the received channel energy to total energy.

The sliding DFT provides a valid result after each sample. The usage of the sliding DFT is important for meeting the time budget to detect high energy received channel transmissions. Furthermore, the check for result stability enables to distinguish between transmission in a received channel and out-of-band emissions of an adjacent channel.

EXAMPLES

Exemplarily, scenarios of FIGS. 1b, 1c and 1d are processed using an embodiment of a state machine operating as in FIG. 6:

**Case** 1: **adjacent channel starting after received channel**

The arrival of a transmission of received channel **110** triggers an action of energy detection. The RF gain is set based on energy. The received channel energy calculated by the DFT during the SP duration indicates that the received channel energy is equal to the total energy. The RF gain does not require adjustment, and a "Lock" state is reached. The baseband filter removes the adjacent channel energy **112.**

**Case 2: adjacent channel starting before received channel**

The arrival of a transmission of adjacent channel **122** triggers energy detection. The RF gain is set based on energy. The received channel energy calculated by the DFT during the SP duration indicates that the received channel energy is much lower than the total energy. Therefore, operation continues while performing a sliding DFT for the duration of a full symbol transmission. Once the received channel transmission **120** arrives, the sliding DFT quickly indicates increased received channel energy. The RF gain is adjusted based on the received channel energy to reach optimal received channel energy level **254.**

**Case 3: adjacent channel energy change**

Energy detection is triggered by the arrival of a transmission of channel **132.** The RF gain is changed when adjacent channel energy **134** is increased. The state machine operation continues as in case 2, supporting all possible adjacent channel energy values.

While this disclosure has been described in terms of certain embodiments and generally associated methods, alterations and permutations of the embodiments and methods will be apparent to those skilled in the art. For example, while the disclosure dealt in detail with vehicular OFDM communications, embodiments of methods and apparatuses disclosed herein can be used in any OFDM communications in which enhanced adjacent channel rejection is desired. It is known that the density of wireless base stations increases, and co-interferences are very common in industrial and residential areas. Methods and apparatuses disclosed herein will improve spatial utilization and performance in such cases of co-interferences. Accordingly, the above description of example embodiments does not define or constrain this disclosure. Other changes, substitutions, and alterations are also possible without departing from the spirit and scope of this disclosure, as defined by the following claims.

All patent applications and publications mentioned in this specification are herein incorporated in their entirety by reference into the specification, to the same extent as if each individual patent application or publication was specifically and individually indicated to be incorporated herein by reference. In addition, citation or identification of any reference in this application shall not be construed as an admission that such reference is available as prior art.

**Claims**

1. A method for adjacent channel interference mitigation during the acquisition phase in OFDM communications, comprising the steps of:

   a) setting an RF gain based on received total energy;
   b) waiting until energy of a received channel is detected; and
   c) adjusting the RF gain based on the detected energy of the received channel, thereby fulfilling an enhanced adjacent channel rejection criterion requirement in the OFDM communications.

2. The method of claim 1, wherein the step of waiting includes waiting while using a discrete Fourier transform (DFT) to detect the received channel energy.

3. The method of claim 2, wherein the DFT is a sliding DFT.

4. The method of claim 2, wherein the using a DFT includes calculating a subset of the DFT for the duration of a short preamble (SP).

5. The method of claim 4, wherein the subset is selected from the group consisting of a subset of 4 subcarriers and a subset of 2 subcarriers.

6. The method of claim 1, wherein the OFDM communications are vehicular OFDM communications.

7. A method for adjacent channel interference mitigation during the acquisition phase in OFDM communications, comprising the steps of:

   a) using a DFT to detect the energy of a received channel; and
   b) adjusting an RF gain based on the detected energy of the received channel, thereby fulfilling an adjacent channel rejection criterion requirement in the OFDM communications.

8. The method of claim 7, wherein the DFT is a sliding DFT.

9. The method of claim 7, wherein the using a DFT includes calculating a subset of the DFT for the duration of a short preamble (SP).

10. The method of claim 9, wherein the subset is selected from the group consisting of a subset of 4 subcarriers and a subset of 2 subcarriers.

11. The method of claim 7, further comprising the step of performing a stability test which demands a substantially constant result representing stable energy, thereby separating the received channel transmission from out-of-band emission of an adjacent channel.

12. An apparatus for adjacent channel interference mitigation during the acquisition phase in OFDM communications, comprising:

   a) a receive signal strength indicator (RSSI) estimator for measuring total energy of input signals;
   b) a Discrete Fourier Transform (DFT) for measuring energy of a received channel; and
   c) a state machine used for processing the measured total energy and received channel energy to fulfill an enhanced adjacent channel rejection criterion requirement in the OFDM communications.

13. The apparatus of claim 12, wherein the DFT is a sliding DFT.

14. The apparatus of claim 13, wherein the DFT is a dynamic DFT with variable length

15. The apparatus of claim 12, wherein the OFDM communications are vehicular OFDM communications.

Relative
energy [dB]

+28dB

+16dB

Adjacent
channel
energy
**104**

Adjacent
channel
energy
**102**

+0dB

Received
channel
energy
**100**

FIG. 1a

Received channel energy **110**

Adjacent channel energy
**112**

t

FIG. 1b

FIG. 1c

FIG.1d

RF gain

Antenna
**200**

Gain control
**204**

Signal

RF
**202**

Baseband
Signal

Flags

Receiver
**206**

Packet

FIG. 2a

**Input level after
amplification [dBm]**

**250**
Saturation

**252**
Maximal level

**254**
Optimal level

**256**
Minimal level

**258**
Implementation
noise floor

FIG. 2 b

Total energy

|
↓

```
┌─────────────────────────────────┐
│  Setting RF gain based on total │
│              energy             │
│               300               │
└─────────────────────────────────┘
```

|
↓

```
┌─────────────────────────────────┐
│    Waiting till received channel│
│           energy exists         │
│               302               │
└─────────────────────────────────┘
```

|
↓

```
┌─────────────────────────────────┐
│     Adjusting RF gain based on  │
│       received channel energy   │
│               304               │
└─────────────────────────────────┘
```

FIG. 3

FIG. 4

FIG. 5

Waiting for total energy
detection
**600**

Setting RF gain based on
RSSI
**602**

Calculating subset of
DFT for SP duration
**604**

Received
channel energy > alpha
* Total energy AND
Is sliding DFT stable?
**606**

Y

N

Adjusting RF gain based
on received channel
energy
**608**

Setting RF gain based on
RSSI
**612**

Lock
**610**

Y

Does
total energy exist?
**614**

N

Calculating subset of
DFT for 4*SP duration
**616**

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO IB2010055197 W

**Non-patent literature cited in the description**

• **E. JACOBSEN ; R. LYONS.** The Sliding DFT. *IEEE Signal Processing Magazine,* March 2003, 74-80